Europäisches Patentamt

(19) European Patent Office

Office européen des brevets

(11) EP 0 939 437 A2

(12) EUROPEAN PATENT APPLICATION

(43) Date of publication:
01.09.1999 Bulletin 1999/35

(51) Int. Cl.⁶: $H01L\ 21/768$, $H01L\ 23/522$

(21) Application number: 99103548.6

(22) Date of filing: 24.02.1999

(84) Designated Contracting States:
AT BE CH CY DE DK ES FI FR GB GR IE IT LI LU
MC NL PT SE
Designated Extension States:
AL LT LV MK RO SI

(30) Priority: 27.02.1998 JP 4780498

(71) Applicant: NEC CORPORATION
Tokyo (JP)

(72) Inventors:
• Matsubara, Yoshihisa,
c/o NEC Corporation
Tokyo (JP)
• Iguchi,Manabu,
c/o NEC Corporation
Tokyo (JP)
• Ito, Nobukazu,
c/o NEC Corporation
Tokyo (JP)
• Suzuki, Mieko,
c/o NEC Corporation
Tokyo (JP)
• Tsuchiya, Yasuaki,
c/o NEC Corporation
Tokyo (JP)

(74) Representative:
Glawe, Delfs, Moll & Partner
Patentanwälte
Postfach 26 01 62
80058 München (DE)

(54) **Planarization of wiring layers**

(57) There is provided a semiconductor device including a semiconductor substrate (1), an insulating layer (4) formed on the semiconductor substrate (1) and formed with at least one recess or hole (5), a barrier metal layer (6) covering an inner wall of the recess or hole (5) therewith, and at least one electrically conductive layer (7) formed on the barrier metal layer (6) to fill the recess or hole (5) therewith, characterized by that assuming that X indicates a maximum depth of a recess or hole (5) in an electrically conductive layer (7) having a longest wiring length, and that Y indicates a thickness of the electrically conductive layer (7) having a longest wiring length, a ratio of Y to X (X/Y) is set equal to or smaller than 0.1. The semiconductor device is capable of avoiding occurrence of dishing in the electrically conductive film (7).

FIG.2

EP 0 939 437 A2

Description

## BACKGROUND OF THE INVENTION

### FIELD OF THE INVENTION

The invention relates to a semiconductor device including an electrically conductive layer formed by chemical mechanical polishing, and further to a method of fabricating such a semiconductor device.

### DESCRIPTION OF THE PRIOR ART

As a semiconductor device has been more highly integrated recently, a wiring layer is required to have a smaller resistance. To this end, a wiring layer has been generally composed of copper (Cu) having a high resistance to electro-migration (EM).

However, if a wiring layer were composed of copper, it would be impossible to carry out dry etching at a sufficient etching rate, resulting in that it would be quite difficult to carry out anisotropic etching in reactive ion etching (RIE).

Hence, when copper is selected as a material of which a wiring layer is composed, there has been widely adopted a method where an electrically conducive film is formed of copper. Such an electrically conductive film is formed by the steps of forming a recess or a contact hole with an insulating layer in accordance with a wiring pattern, filling the recess or contact hole with a copper layer, and removing an unnecessary portion of the copper layer by chemical mechanical polishing (hereinafter, referred to simply as "CMP").

When an electrically conductive layer is composed of copper, it is necessary to form a barrier metal layer such as a TiN layer between an insulating layer and the electrically conductive layer. This is because if an electrically conductive layer composed of copper is formed directly on an insulating film such as a silicon dioxide film, copper readily diffuses among silicon dioxide molecules to thereby establish a deep level in silicon semiconductor, which would shorten lifetime of minority carriers.

An example of a method of forming an electrically conductive film has been suggested in Japanese Unexamined Patent Publication No. 9-69522.

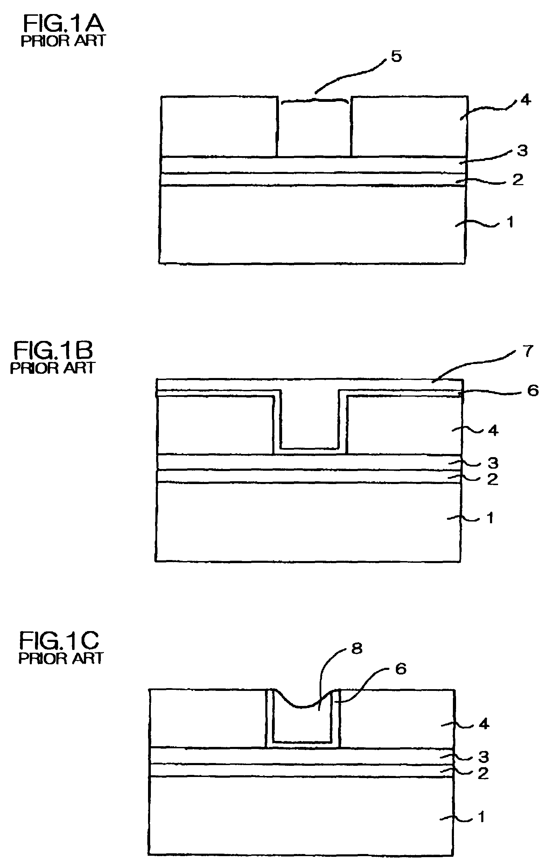

Figs. 1A to 1C illustrates respective steps of the method suggested in the Publication.

First, as illustrated in Fig. 1A, a silicon dioxide layer 2 acting as an underlying insulating layer, and a tungsten wiring layer 3 are deposited on a silicon substrate 1. Then, a silicon dioxide layer 4 is deposited on the tungsten wiring layer 3 by plasma-enhanced chemical vapor deposition (PCVD) by a thickness of 600 nm.

Then, a photoresist film (not illustrated) having a thickness of 0.6 μm is formed on the silicon dioxide layer 4, and thereafter, is patterned by means of i-ray having a wavelength of 365 nm. The silicon dioxide layer 4 is etched using the thus patterned photoresist film as a mask, to thereby form a contact hole 5 throughout the silicon dioxide layer 4. The contact hole 5 has a width of 0.5 μm and a depth of 1 μm, which means that the contact hole 5 has an aspect ratio of 2, and reaches the tungsten wiring layer 3.

Then, as illustrated in Fig. 1B, a TiN layer 6 is deposited over the silicon dioxide layer 4 and the exposed tungsten wiring layer 3 by chemical vapor deposition (hereinafter, referred to simply as "CVD") or sputtering. Sputtering is inferior to CVD with respect to coverage ability for covering steps therewith, but is superior to CVD with respect to barrier performance.

Then, a copper layer 7 is formed entirely over the TiN layer 6 so that the contact hole 5 is filled with the copper layer 7.

Then, unnecessary portions of the copper layer 7 and the TiN layer 6, that is, portions of the copper layer 7 and the TiN layer 6 existing above the contact hole 5, are removed by CMP under following conditions.

    Polishing slurry: alumina particle
    Polishing pressure: 200 to 300 g/cm$^2$
    r.p.m.: 50 to 100
    Polishing time: 1 to 2 minutes

Thus, as illustrated in Fig. 1C, there is completed a buried copper contact electrode 8.

However, the above-mentioned problem is accompanied with a problem that the copper contact electrode 8 is recessed, as illustrated in Fig. 1C, as a result of removal of the unnecessary portions of copper layer 7 and the TiN layer 6 by CMP. The reason is as follows. Copper has a polishing rate significantly greater than a polishing rate of TiN. Hence, when the TiN layer 6 formed on the silicon dioxide layer 4 is removed by CMP, the copper layer 7 is polished too excessively while the TiN layer 6 is being polished. As a result, the copper layer 7 is recessed at a center thereof in the shape of a dish (hereinafter, a recess formed in the center of the copper contact electrode 8 is referred to as "dishing").

Since it would be necessary to carry out over-etching to some degree in order to almost completely remove the unnecessary portion of the TiN layer 6, it would be unavoidable for the copper contact electrode 8 to have a remarkable dishing. Dishing would be more remarkable in an electrically conductive layer having a greater length.

If dishing is generated in a copper layer, a resistance is locally increased, which would cause electro-migration with the result of deterioration in reliability of a semiconductor device including the copper layer.

Japanese Unexamined Patent Publication No. 9-306915 has suggested a method of removing a defect generated in a copper layer while the copper layer is being polished by CMP. The suggested method includes the steps of forming a groove with a silicon dioxide film formed on a semiconductor substrate, depositing a barrier metal composed of TiN by sputtering, depositing a copper film on the barrier metal, filling the groove with the copper film by reflow, removing an unnecessary portion of the copper film by CMP so that the groove remains filled with the copper film, and applying heat treatment to the product in hydrogen atmosphere to thereby eliminate defects having been generated in the copper layer.

However, a combination of reflow and heat treatment in hydrogen atmosphere cannot sufficiently eliminate defects such as dishing.

## SUMMARY OF THE INVENTION

It is an object of the present invention to provide a semiconductor device including an electrically conductive layer free of dishing. It is also an object of the present invention to provide a method of fabricating such a semiconductor device.

The present invention accomplishes the above-mentioned objects by increasing a polishing rate at which a barrier metal layer is polished by CMP.

In one aspect of the invention, there is provided a semiconductor device including (a) a semiconductor substrate, (b) an insulating layer formed on the semiconductor substrate and formed with at least one recess or hole, (c) a barrier metal layer covering an inner wall of the recess or hole therewith, and (d) at least one electrically conductive layer formed on the barrier metal layer to fill the recess or hole therewith, characterized by that assuming that X indicates a maximum depth of a recess in an electrically conductive layer having a longest wiring length, and that Y indicates a thickness of the electrically conductive layer having a longest wiring length, a ratio of Y to X (X/Y) is set equal to or smaller than 0.1.

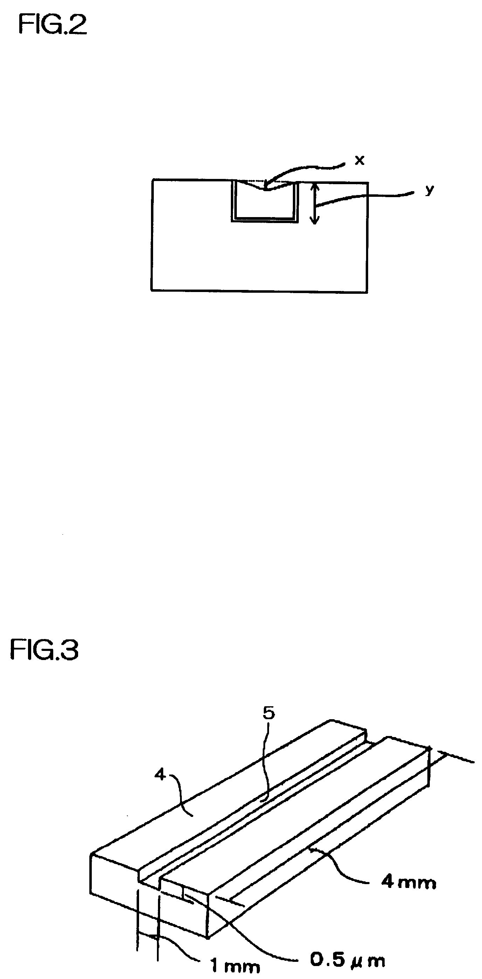

As mentioned earlier, in the conventional method of fabricating a semiconductor device, dishing is generated at a surface of an electrically conductive film when an unnecessary portion of a barrier metal film is removed by CMP. Herein, as illustrated in Fig. 2, dishing generated at a surface of an electrically conductive film is defined as a ratio of Y to X (X/Y) where X indicates a depth of dishing, and Y indicates a thickness of an electrically conductive film. The ratio X/Y is greater in an electrically conductive film having a greater wiring length.

The present invention provides a semiconductor device in which an electrically conductive film having a longest wiring length is designed to have the ratio X/Y equal to or smaller than 0.1. It is preferable that the ratio of Y to X is equal to or smaller than 0.05. The semiconductor device can be fabricated, as mentioned later, by decreasing a density of a barrier metal layer, which is accomplished, for instance, by optimizing sputtering conditions for forming a barrier metal layer.

There is further provided a semiconductor device including (a) a semiconductor substrate, (b) an insulating layer formed on the semiconductor substrate and formed with at least one recess or hole, (c) a barrier metal layer covering an inner wall of the recess or hole therewith, and (d) at least one electrically conductive layer formed on the barrier metal layer to fill the recess or hole therewith, characterized by that a dishing index defined as a resistance to dishing is set equal to or greater than 0.4.

A degree of dishing in an electrically conductive film is dependent on a lot of factors including (a) materials of which a barrier metal layer and an electrically conductive film are composed, (b)thicknesses of a barrier metal layer and an electrically conductive film, (c) a configuration of a contact hole which is to be filled with copper, (d) a degree of over-etching, and (e) polishing conditions of CMP. Among these factors, the factors (b)to (e) are subject to other restrictions in a process of fabricating a semiconductor device.

Hence, the present invention is focused on the factor (a). The present invention uses a parameter called dishing index indicating a resistance to dishing in a barrier metal layer and an electrically conductive film, and defines a preferable range of the dishing index. In brief, the dishing index is a parameter which is defined with a combination of a barrier metal layer and an electrically conductive layer, and is dependent on materials of which those layers are composed, and a process by which those layers are formed. Hereinbelow is detailed the dishing index.

The dishing index indicative a resistance to dishing is measured in an experiment where materials of which a barrier metal layer and an electrically conductive layer are composed, and conditions for forming those layers are standardized in such a manner that dishing is readily generated.

Specifically, in the experiment, as illustrated in Fig. 3, an insulating layer 4 is formed with a groove 5 by which an electrically conductive film having a relatively great length is formed. A refractory metal film and an electrically conductive film are formed over the groove 5 in accordance with the steps illustrated in Figs. 1A to 1C. Then, unnecessary portions of those films are removed by CMP. As mentioned earlier, there is generated dishing in the electrically conductive film, as illustrated in Fig. 1C. The dishing index is measured by estimating the thus generated dishing.

In the experiment, the groove 5 is designed to have a length of 4 mm, a width of 1 mm, and a depth of 500 nm, and the barrier metal layer is designed to have a thickness of 50 nm. CMP is conducted at r.p.m. of 25 under a pressure of 2 psi. Polishing slurry is alumina particle suspension containing hydrogen peroxide ($H_2O_2$) therein. For instance, there may be used alumina particle suspension commercially available from RoDale in the tradename of QCTT1010.

Dishing is made to generate in the electrically conductive film under the above-mentioned conditions. The dishing index is defined as a depth X (see Fig. 2) of the thus generated dishing in the center of the electrically conductive film, divided by a thickness Y (see Fig. 2) of 500 nm of the electrically conductive film.

That is, the dishing index indicates a resistance to dishing obtained when an electrically conductive film and a barrier metal layer constituting a semiconductor device under test are applied to the groove 5 illustrated in Fig. 3. In other words, the dishing index indicates a resistance to dishing of a sample where an electrically conductive film and a barrier metal film are applied to the groove 5 illustrated in Fig. 3 with both materials of which those films are composed and processes of forming those films being kept unchanged and only configuration of those films being varied.

Table 1 shows a relation between the dishing index and a degree of dishing generated when a contact hole or a wiring layer has been actually formed. In order to reduce dishing down to a level at which no practical problem is caused, the dishing index is set equal to or smaller than 0.4, more preferably 0.2, and most preferably 0.1. The present invention defines a range of the dishing index in the above-mentioned standpoint.

[Table 1]

| Size of a buried electrically conductive layer in an actual semiconductor device | Dishing index corresponding to 10% dishing |
|---|---|
| (An electrically conductive layer buried in a contact hole) | |
| 1 µm × 1 µm | 0.1 |
| 0.6 µm × 0.6 µm | 0.2 |
| 0.4 µm × 0.4 µm | 0.3 |
| 0.35 µm × 0.35 µm | 0.4 |
| 0.28 µm × 0.28 µm | 0.7 |
| (An electrically conductive layer buried in a groove) | |
| (Wiring length = 15 mm) | |
| Wiring width 0.35 µm | 0.1 |
| Wiring width 0.25 µm | 0.2 |
| Wiring width 0.18 µm | 0.4 |

In the Table 1, "dishing index corresponding to 10% dishing" means dishing index measured when the electrically conductive layer listed in the left column is caused to have 10% dishing. For instance, if the dishing index is set equal to 0.1, a semiconductor device including a buried electrically conductive layer formed in a contact hole having a size of 1 µm × 1 µm would have a degree of dishing at 10%. For another instance, a semiconductor device including a buried electrically conductive layer formed in a groove having a wiring length of 15 µm and a wiring width of 35 µm would have a degree of dishing at 10%.

There is still further provided a semiconductor device including (a) a semiconductor substrate, (b) an insulating layer formed on the semiconductor substrate and formed with at least one recess, (c) a barrier metal layer covering an inner wall of the recess therewith, the barrier metal layer having a first polishing rate at which the barrier metal layer is polished by chemical mechanical polishing, and (d) at least one electrically conductive layer formed on the barrier metal layer to fill the recess therewith, the electrically conductive layer having a second polishing rate at which the electrically conductive layer is polished by chemical mechanical polishing, characterized by that the first polishing rate is set at least $2.6 \times 10^{-2}$ times greater than the second polishing rate.

Generation of dishing is originated from a difference in a polishing rate between an electrically conductive film and a barrier metal layer. The present invention prevents generation of dishing by increasing a polishing rate of an electrically conductive film to thereby increase a ratio of a polishing rate of an electrically conductive film to a polishing rate of a barrier metal layer. Dishing can be reduced down to a level at which no practical problem is caused, by setting a ratio of a polishing rate at which a barrier metal layer is polished by CMP to a polishing rate at which an electrically conductive film is polished by CMP, equal to or greater than $2.6 \times 10^{-2}$, more preferably $5.3 \times 10^{-2}$.

A barrier metal film composed of refractory material such as refractory metal nitride has a significantly smaller polishing rate than that of an electrically conductive film composed of copper. Hence, the above-mentioned ratio is usually equal to or smaller than 1.

There is yet further provided a semiconductor device including (a) a semiconductor substrate, (b) an insulating layer formed on the semiconductor substrate and formed with at least one recess, (c) a barrier metal layer covering an inner wall of the recess therewith, and (d) at least one electrically conductive layer formed on the barrier metal layer to fill the recess therewith, characterized by that a polishing rate at which the barrier metal layer is polished by chemical mechanical polishing is set equal to or greater than 40 angstroms per minute.

The present invention prevents generation of dishing by increasing a polishing rate of an electrically conductive film to thereby increase a ratio of a polishing rate of an electrically conductive film to a polishing rate of a barrier metal layer. Dishing can be reduced down to a level at which no practical problem is caused, by setting a polishing rate at which a barrier metal layer is polished by CMP equal to or greater than 40 angstroms per minute, more preferably, 80 angstroms per minute.

A barrier metal film composed of refractory material such as refractory metal nitride has a significantly smaller polishing rate than a polishing rate of an electrically conductive film composed of copper (1000 angstroms per minute).

There is still yet further provided a semiconductor device including (a) a semiconductor substrate, (b) an insulating layer formed on the semiconductor substrate and formed with at least one recess, (c) a barrier metal layer covering an inner wall of the recess therewith, and (d) at least one electrically conductive layer formed on the barrier metal layer to fill the recess therewith, characterized by that the barrier metal layer is designed to have a compressive stress equal to or smaller than $3 \times 10^8$ dyne/cm$^2$.

Since a compressive stress in the semiconductor device is designed smaller than a compressive stress in a conventional semiconductor device, it is possible to increase a polishing rate at which a barrier metal layer is polished by CMP, resulting in reduction in dishing. A compressive stress in a barrier metal layer can be measured based on a dimension and a curvature of a substrate.

There is further provided a semiconductor device including (a) a semiconductor substrate, (b) an insulating layer formed on the semiconductor substrate and formed with at least one recess, (c) a barrier metal layer covering an inner wall of the recess therewith, and (d) at least one electrically conductive layer formed on the barrier metal layer to fill the recess therewith, characterized by that the barrier metal layer is designed to have a density equal to or smaller than $6 \times 10^{22}$ atoms/cm$^3$.

Since a barrier metal layer in the semiconductor device is designed to have a smaller density than a density of a barrier metal layer in a conventional semiconductor device, it is possible to increase a polishing rate at which a barrier metal layer is polished by CMP, resulting in reduction in dishing. A density of a barrier metal layer in the semiconductor device has no lower limit, unless performances of the barrier metal layer are not deteriorated. A density of the barrier metal layer is calculated based on a thickness and a weight thereof.

In the semiconductor devices mentioned above, it is preferable that the electrically conductive layer is composed of copper or copper compounds, and the barrier metal layer is composed of refractive metal nitride. Refractive metal nitride of which the barrier metal layer is composed may be selected from WN, TiN, or TaN, among which TiN or TaN is more preferably used.

In another aspect of the present invention, there is provided a method of fabricating a semiconductor device, including the steps of (a) forming an insulating film on a semiconductor substrate, (b) forming a recess with the insulating film, (c) forming a barrier metal layer over an inner wall of the recess by sputtering, (d) forming an electrically conductive layer over the barrier metal layer to fill the recess therewith, and over the insulating film, and (e) removing the electrically conductive layer by chemical mechanical polishing in such a manner that the recess remains filled with the electrically conductive layer, characterized by that the sputtering is carried out under at least one of the following conditions:

(A) sputtering power is equal to or smaller than 1.5 kW;
(B) sputtering pressure is equal to or greater than 8 mTorr; and
(C) a temperature of the substrate is equal to or greater than 360 degrees centigrade.

It is preferable that the barrier metal layer is formed by sputtering for enhancing barrier ability. By appropriately setting sputtering conditions, it is possible to increase a polishing rate of a barrier metal layer to thereby reduce dishing. Conditions for doing so are the above-mentioned ones (A) to (C). The method is required to meet with at least one of the conditions (A) to (C). If the method meets with two or three conditions, it would be possible to further increase a polishing rate of a barrier metal layer to thereby further reduce dishing.

When the sputtering power is set equal to or smaller than 1.5 kW, it would be possible to further increase a polishing rate of a barrier metal layer by setting a sputtering pressure to be equal to or greater than 3 mTorr and/or setting a temperature of a substrate at which the sputtering is to be carried out to be equal to or greater than 200 degrees centigrade.

When the sputtering pressure is equal to or greater than 8 mTorr, it would be possible to further increase a polishing rate of a barrier metal layer by setting a sputtering power to be equal to or smaller than 4.5 kW and/or setting a temperature of a substrate at which the sputtering is to be carried out to be equal to or greater than 200 degrees centigrade.

When a temperature of the substrate is set equal to or greater than 360 degrees centigrade, it would be possible to further increase a polishing rate of a barrier metal layer by setting a sputtering power to be equal to or smaller than 4.5 kW and/or setting a sputtering pressure to be equal to or greater than 3 mTorr.

There is further provided a method of fabricating a semiconductor device, including the steps of (a) forming an insulating film on a semiconductor substrate, (b) forming a recess with the insulating film, (c) forming a barrier metal layer over an inner wall of the recess by sputtering, (d) forming an electrically conductive layer over the barrier metal layer to fill the recess therewith, and over the insulating film, and (e) removing the electrically conductive layer by chemical mechanical polishing in such a manner that the recess remains filled with the electrically conductive layer, characterized by that the sputtering is carried out under following conditions:

$$W/P \leqq 0.4 \text{ and } T \geqq 200$$

wherein W indicates a sputtering power in the unit of kW, P indicates a sputtering pressure in the unit of mTorr, and T indicates a substrate temperature when the sputtering is carried out, in the unit of degrees centigrade.

By setting sputtering conditions in such a manner as mentioned above, it is possible to decrease a density of a barrier metal layer and increase a polishing rate of a barrier metal layer. In the method, a ratio of W/P is set equal to or smaller than 0.4, more preferably, 0.3. The reason why the ratio of W/P is set equal to or smaller than a certain constant is to reduce acceleration energy per a sputtered particle to thereby lower a density of a barrier metal layer. This is detailed later.

A substrate is more advantageously kept at a higher temperature during sputtering. A substrate is kept preferably at 200 degrees centigrade, and more preferably at 300 degrees centigrade.

In the above-mentioned methods, it is preferable that the electrically conductive film is composed of copper or copper compounds, and the barrier metal layer is composed of TiN.

In a preferred embodiment, the electrically conductive layer is composed of copper or copper compounds, and the barrier metal layer is composed of TaN, and the sputtering is carried out under following conditions:

$$W/P \leqq 0.35 \text{ and } T \geqq 200$$

wherein W indicates a sputtering power in the unit of kW, P indicates a sputtering pressure in the unit of mTorr, and T indicates a substrate temperature when the sputtering is carried out, in the unit of degrees centigrade.

By setting sputtering conditions in such a manner as mentioned above, it is possible to decrease a density of a barrier metal layer and increase a polishing rate of a barrier metal layer. In the method, a ratio of W/P is set equal to or smaller than 0.35, more preferably, 0.3.

Hereinbelow is explained the reason why a polishing rate can be increased by appropriately setting sputtering conditions.

A polishing rate is dependent on a density of a film to be polished, and becomes higher in a film having a smaller density. A density of a film formed by sputtering is dependent on sputtering power, sputtering pressure, and a temperature of a substrate during sputtering is being carried out. This is because a density of a film varies in dependence on acceleration energy to be applied to sputtered particles.

For instance, if sputtering power is set higher, a sputtered particle would have higher acceleration energy, and hence, there would be formed a film into which sputtered particles are incorporated in a higher density. As a result, the resultant film would have a higher density.

As an alternative, if sputtering pressure were set lower, each one of sputtered particles would have higher acceleration energy even when sputtering power is kept constant, resulting in an increase in a density of the film.

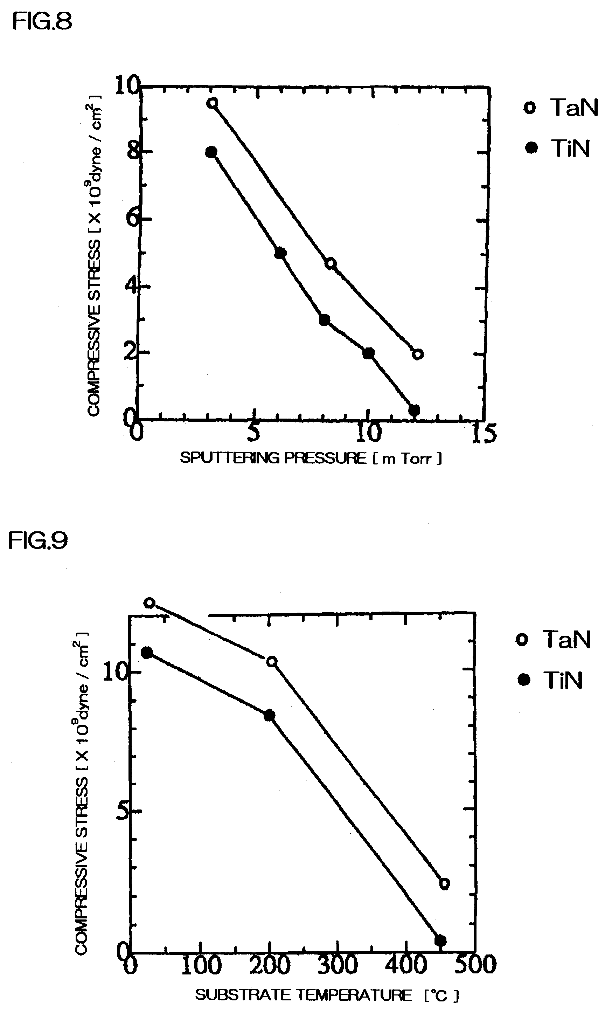

It is not always clear as to why a polishing rate of a barrier metal layer is increased, if a substrate temperature is increased. However, it has been confirmed by the experiments which the inventors had conducted that a higher substrate temperature is more effective for reducing dishing, as illustrated in Fig. 9.

## BRIEF DESCRIPTION OF THE DRAWINGS

Figs. 1A to 1C are cross-sectional views of a semiconductor device, illustrating respective steps of a conventional method of fabricating the same.

Fig. 2 is a partial cross-sectional view of a semiconductor device, illustrating dishing generated in an electrically conductive film.

Fig. 3 is a perspective view of a semiconductor device, showing how to measure dishing index.

Fig. 4 is a graph showing a relation between a compressive stress in a barrier metal layer and a polishing rate at which a barrier metal layer is polished by CMP.

Fig. 5 is a graph showing a relation between a compressive stress in a barrier metal layer and a density of a barrier metal layer.

Fig. 6 is a graph showing a relation between a polishing rate at which a barrier metal layer is polished by CMP and dishing index.

Fig. 7 is a graph showing a relation between sputtering power and a compressive stress in a barrier metal layer.

Fig. 8 is a graph showing a relation between a sputtering pressure and a compressive stress in a barrier metal layer.

Fig. 9 is a graph showing a relation between a substrate temperature during sputtering and a compressive stress in a barrier metal layer.

Figs. 10A to 10C are cross-sectional views of a semiconductor device, illustrating respective steps of a method of fabricating the same, in accordance with the present invention.

## DESCRIPTION OF THE PREFERRED EMBODIMENTS

The present invention reduces a degree of dishing by increasing a polishing rate at which a barrier metal layer is polished by CMP. The polishing rate can be increased by reducing a density of a barrier metal layer. However, reduction in a density of a barrier metal layer is accompanied with reduction in a compressive stress in a barrier metal layer.

Hereinbelow is explained a relation between reduction in a density of a barrier metal layer and reduction in a compressive stress in a barrier metal layer in an example where a barrier metal layer is composed of TiN and an electrically conductive layer is composed of copper.

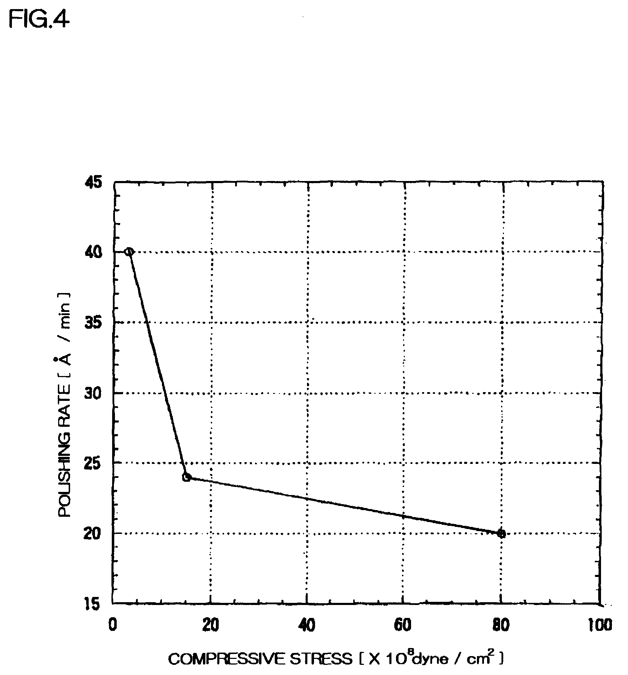

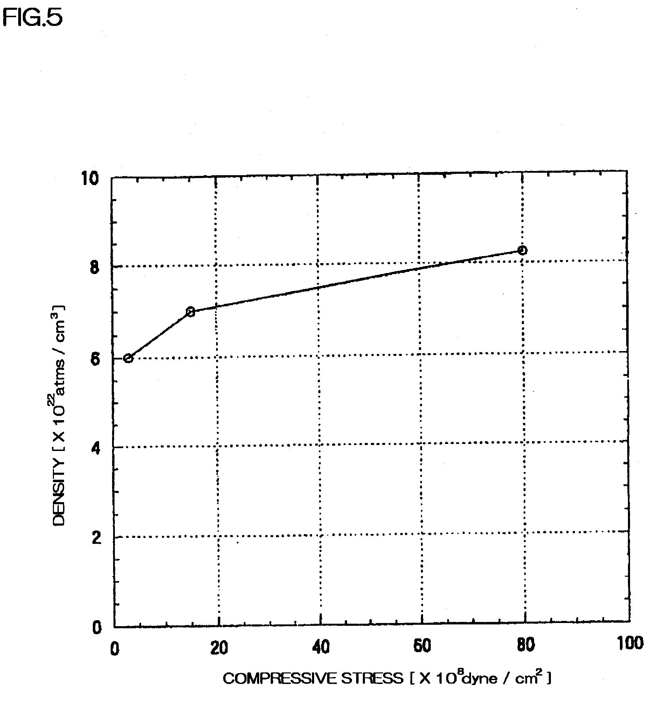

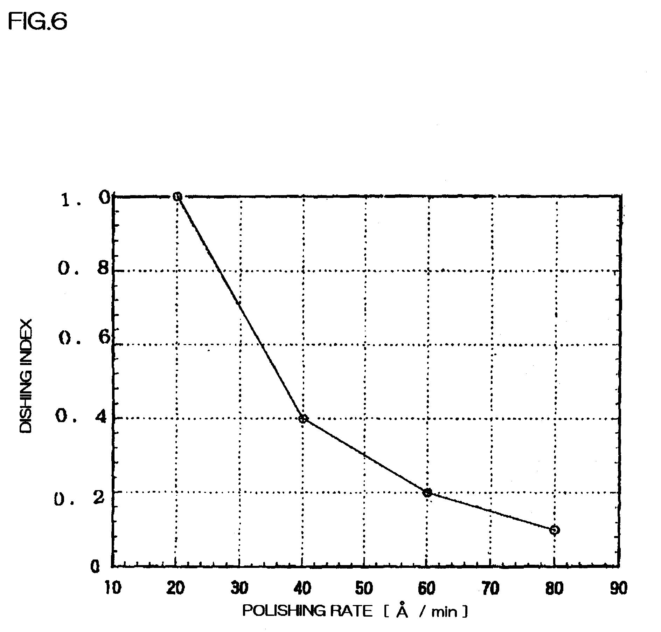

Fig. 4 shows a relation between a compressive stress in a barrier metal layer and a polishing rate at which a barrier metal layer is polished by CMP, Fig. 5 shows a relation between a compressive stress in a barrier metal layer and a density of a barrier metal layer, and Fig. 6 shows a relation between a polishing rate at which a barrier metal layer is polished by CMP and dishing index. Table 2 shows those relations.

[Table 2]

| Compressive Stress ($\times 10^8$ dyne/cm$^3$) | Film Density ($\times 10^{22}$ atoms/cm$^3$) | Polishing Rate ($\times$ angstroms/minute) | Ratio between Polishing Rates ($\times 10^{-2}$) | Dishing Index |
|---|---|---|---|---|
| | | 80 | 5.3 | 0.1 |
| | | 60 | 4.0 | 0.2 |
| 3 | 6.0 | 40 | 2.6 | 0.4 |
| 10 | 6.5 | 30 | 2.0 | (0.7) |
| 15 | 7.0 | 24 | 1.6 | (0.9) |
| 80 | 8.3 | 20 | 1.3 | 1 |

No practical problem is caused in a semiconductor device at a degree of dishing level at which a ratio defined as X/Y is equal to or smaller than 0.1, where X indicates a depth of dishing generated in an electrically conductive film, and Y indicates a thickness of an electrically conductive film, as defined in Fig. 2.

In order to accomplish the ratio X/Y equal to or smaller than 0.1, the dishing index is necessary to be equal to or smaller than 0.4, more preferably 0.2, and most preferably 0.1, in view of Table 1.

In view of Table 2, in order to design the dishing index to be equal to or smaller than 0.4, at least one of the followings (a) to (d) has to be accomplished.

(a) A barrier metal layer has a density equal to or smaller than $6 \times 10^{22}$ atoms/cm$^3$.

(b) A ratio of a polishing rate of a barrier metal layer to a polishing layer of an electrically conductive layer is equal to or greater than $2.6 \times 10^{-2}$. (A copper layer has a polishing rate of 1500 angstroms per minute.)

(c) A barrier metal layer has a polishing rate equal to or greater than 40 angstroms per minute.

(d) A barrier metal layer has a compressive stress equal to or smaller than $3 \times 10^8$ dyne/cm$^2$.

Accordingly, the dishing index can be designed to be equal to or smaller than 0.4, and hence, a degree of dishing can be reduced to a degree at which no practical problem is caused in a semiconductor device, by forming a barrier metal layer meeting with at least one of the above-mentioned conditions (a) to (d).

Designing the dishing index to be equal to or smaller than 0.2 is equivalent to designing a ratio of a polishing rate of a barrier metal layer and a polishing rate of an electrically conductive film to be equal to or greater than $4.0 \times 10^{-2}$, or designing a polishing rate of a barrier metal layer to be equal to or greater than 60 angstroms per minute. Designing the dishing index to be equal to or smaller than 0.1 is equivalent to designing a ratio of a polishing rate of a barrier metal layer and a polishing rate of an electrically conductive film to be equal to or greater than $5.3 \times 10^{-2}$, or designing a polishing rate of a barrier metal layer to be equal to or greater than 80 angstroms per minute.

In the above-mentioned example, a barrier metal layer is composed of TiN, and an electrically conductive film is composed of copper. There is obtained the same relation as mentioned above, if a barrier metal layer is composed of TaN, and an electrically conductive film is composed of copper.

Reduction in the dishing index is accomplished in the present invention by increasing a polishing rate at which a barrier metal layer is polished by CMP. This is because a principal factor for a polishing rate and a compressive stress is a density of a barrier metal layer.

A density and a compressive stress of a barrier metal layer have no lower limit in principle, but actually have a lower limit based on performances of a sputtering apparatus. For instance, a compressive stress becomes lower and a density becomes smaller in lower sputtering power. However, if sputtering power were set equal to or smaller than 0.2 kW reproducibility provided by existing sputtering apparatuses would be deteriorated.

As an alternative, a compressive stress becomes lower and a density becomes smaller in a higher sputtering pressure. However, if a sputtering pressure is set too high, plasma is not generated with the result of inability of sputtering. Such a critical pressure at which sputtering cannot be carried out is dependent on apparatuses, and hence, it is necessary to know a pressure range in which sputtering can be carried out, for each of sputtering apparatuses.

Similarly, a substrate temperature has no upper limit in principle, but has actual upper limit dependent on performances of sputtering apparatuses.

Accordingly, it is necessary to select sputtering power, sputtering pressure, and substrate temperature in dependence on performances of a sputtering apparatus to be employed, in order to obtain a desired dishing index, to thereby decrease a density of a barrier metal layer as much as possible

Since a ratio between polishing rates and a polishing rate of a barrier metal layer are dependent on a density of a barrier metal layer, they have upper limits based on performances of a sputtering apparatus, similarly to the above-mentioned parameters.

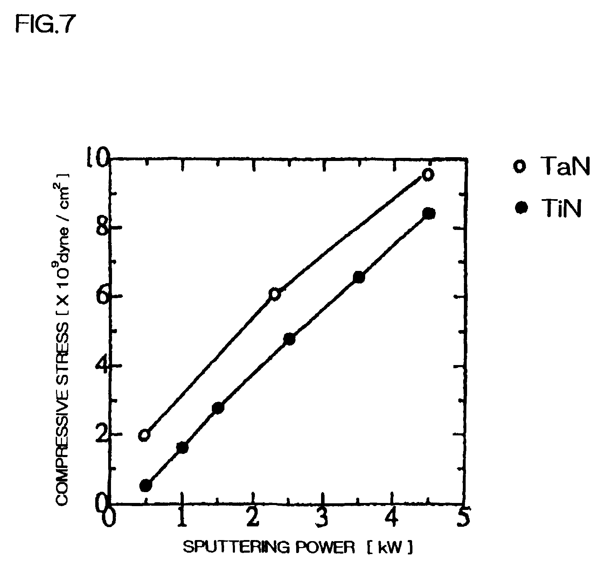

As mentioned earlier, it is effective to decrease a density of a barrier metal layer to thereby increase a polishing rate of the same, in order to reduce dishing in an electrically conductive film. In order to decrease a density of a barrier metal layer, sputtering power may be decreased, or sputtering conditions may be optimized. Hereinbelow are explained means for decreasing a density of a barrier metal layer, with reference to Figs. 7 to 9. Fig. 7 shows a relation between sputtering power and a compressive stress in a barrier metal layer, Fig. 8 shows a relation between a sputtering pressure and a compressive stress in a barrier metal layer, and Fig. 9 shows a relation between a substrate temperature during sputtering and a compressive stress in a barrier metal layer.

As illustrated in Fig. 4, a compressive stress in a barrier metal layer has negative correlation with a polishing rate of a barrier metal layer, and as illustrated in Fig. 6, a polishing rate of a barrier metal layer has negative correlation with the dishing index. Accordingly, a greater compressive stress indicates a greater dishing index. As mentioned earlier, it is necessary to design the dishing index equal to or smaller than 0.4 in order to reduce a degree of dishing down to a level at which no practical problem is caused in a actually used semiconductor device. In view of Table 2, designing the dishing index equal to or smaller than 0.4 is equivalent to designing a compressive stress equal to or smaller than $3 \times 10^8$ dyne/cm$^2$. Hence, in view of Figs. 7 to 9, it is desired to select sputtering conditions so that a compressive stress becomes as small as possible. Specifically, it is desired to select sputtering conditions which would define a compressive stress in a barrier metal layer to be equal to or smaller than $3 \times 10^8$ dyne/cm$^2$.

In Fig. 7, sputtering condition meeting with the above-mentioned requirement is that sputtering power is equal to or smaller than 0.5 kW. The graph in Fig. 7 is based on measurements obtained when a sputtering pressure is equal to 3 mTorr and a substrate temperature is equal to 200 degrees centigrade. A compressive stress becomes lower in a higher sputtering pressure and/or at a higher substrate temperature. This is because Figs. 8 and 9 shows that a compressive stress becomes lower in a higher sputtering pressure and/or at a higher substrate temperature. Accordingly, when sputtering power is set equal to 0.5 kW a compressive stress can be further reduced by setting a sputtering pressure equal to or greater than 3 mTorr and/or by setting a substrate temperature equal to or greater than 200 degrees centigrade.

In view of Fig. 8, a compressive stress is equal to or smaller than $3 \times 10^8$ dyne/cm$^2$ when a sputtering pressure is equal to or greater than 12 mTorr. The graph in Fig. 8 is based on measurements obtained when sputtering power is equal to 4.5 kW and a substrate temperature is equal to 200 degrees centigrade. Hence, a compressive stress can be further reduced by setting sputtering power equal to or smaller than 4.5 kW and/or by setting a substrate temperature equal to or greater than 200 degrees centigrade.

In view of Fig. 9, a compressive stress is equal to or smaller than $3 \times 10^8$ dyne/cm$^2$ when a substrate temperature is equal to or greater than 450 degrees centigrade. The graph in Fig. 9 is based on measurements obtained when sputtering power is equal to 4.5 kW and a sputtering pressure is equal to 3 mTorr. Hence, a compressive stress can be further reduced by setting sputtering power equal to or smaller than 4.5 kW and/or by setting a sputtering pressure equal to or greater than 3 mTorr.

Hereinbelow are explained examples where semiconductor devices in accordance with the present invention had been actually fabricated.

[Example 1]

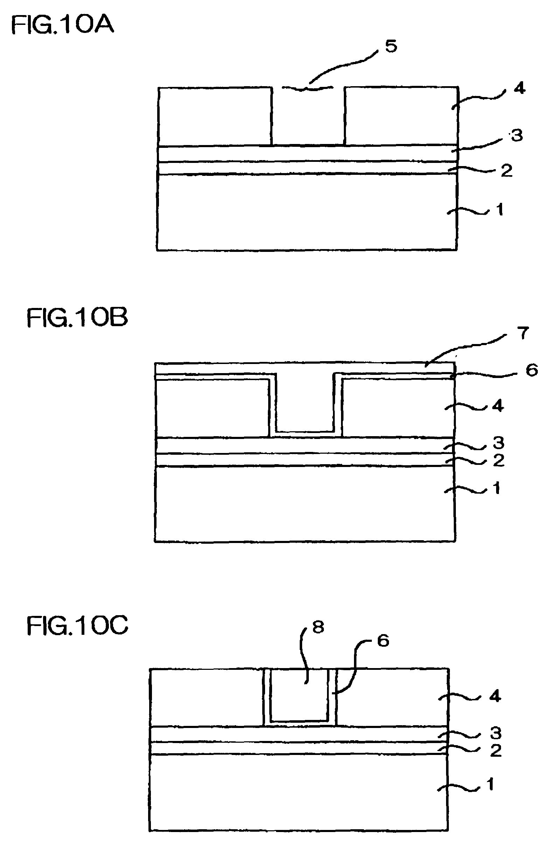

First, as illustrated in Fig. 10A, a silicon dioxide layer 2 acting as an underlying insulating layer, and a tungsten wiring layer 3 were deposited in this order on a silicon substrate 1. Then, a silicon dioxide layer 4 was deposited on the tungsten wiring layer 3 by PCVD by a thickness of 600 nm.

Then, a photoresist film (not illustrated) having a thickness of 0.6 μm was formed on the silicon dioxide layer 4, and thereafter, was patterned by means of i-ray having a wavelength of 365 nm. The silicon dioxide layer 4 was etched using the thus patterned photoresist film as a mask, to thereby form a contact hole 5 throughout the silicon dioxide layer 4. The contact hole 5 had a width of 0.5 μm and a depth of 1 μm which means that the contact hole 5 has an aspect ratio of 2, and reached the tungsten wiring layer 3.

Then, as illustrated in Fig. 10B, a TiN layer 6 as a barrier metal layer was deposited over both the silicon dioxide layer 4 and the exposed tungsten wiring layer 3 by sputtering under the following sputtering conditions.

    Sputtering power: 0.5 kW
    Sputtering pressure: 3 mTorr
    Substrate temperature: 200°C

Then, a copper layer 7 was formed entirely over the TiN layer 6 so that the contact hole 5 was filled with the copper layer 7.

Then, unnecessary portions of the copper layer 7 and the TiN layer 6, that is, portions of the copper layer 7 and the TiN layer 6 existing above the contact hole 5, were removed by CMP under the following conditions.

    Polishing slurry: alumina particle
    Polishing pressure: 2 psi
    r.p.m.: 25
    Polishing time: 1 to 2 minutes

Thus, as illustrated in Fig. 10C, there was completed a buried copper contact electrode 8.

The thus formed copper contact electrode 8 was estimated as to whether dishing was generated therein. The results are shown in Table 3. In Table 3, "NO" in the column titled "Dishing" means that dishing was not generated or a degree of dishing was equal to or smaller than 0.1 (10%) even though dishing was generated, and "YES" means that a degree of dishing was greater than 0.1 (10%).

[Example 2]

Example 2 was carried out in the same manner as Example 1 except that the TiN layer 6 was formed in the following sputtering conditions.

Sputtering power: 4.5 kW
Sputtering pressure: 12 mTorr
Substrate temperature: 200°C

[Example 3]

Example 3 was carried out in the same manner as Example 1 except that the TiN layer 6 was formed in the following sputtering conditions.

Sputtering power: 4.5 kW
Sputtering pressure: 3 mTorr
Substrate temperature: 450°C

[Example 4]

Example 4 was carried out in the same manner as Example 1 except that a barrier metal layer 6 was composed of TaN, and was deposited under the following sputtering conditions.

Sputtering power: 0.5 kW
Sputtering pressure: 6 mTorr
Substrate temperature: 200°C

[Example 5]

Example 5 was carried out in the same manner as Example 1 except that a barrier metal layer 6 was composed of TaN, and was deposited under the following sputtering conditions.

Sputtering power: 4.5 kW
Sputtering pressure: 15 mTorr
Substrate temperature: 200°C

[Reference 1]

Reference 1 was carried out in the same manner as Example 1 except that the TiN layer 6 as a barrier metal layer was deposited under the following sputtering conditions.

Sputtering power: 2.5 kW
Sputtering pressure: 3 mTorr
Substrate temperature: 200°C

[Reference 2]

Reference 2 was carried out in the same manner as Example 1 except that a barrier metal layer 6 was composed of TaN, and was deposited under the following sputtering conditions.

Sputtering power: 2.5 kW
Sputtering pressure: 3 mTorr
Substrate temperature: 200°C

Examples 2 to 5 and References 1 to 2 were also estimated as to whether dishing was generated therein. The results are shown in Table 3.

[Table 3]

|  | Barrier Metal Layer | Sputtering Power [kW] | Sputtering Pressure [mTorr] | Sputtering Power / Sputtering Pressure | Substrate Temp.[°C] | Dishing |
|---|---|---|---|---|---|---|
| Example 1 | TiN | 0.5 | 3 | 0.17 | 200 | NO |
| Example 2 | TiN | 4.5 | 12 | 0.38 | 200 | NO |
| Example 3 | TiN | 4.5 | 3 | 1.5 | 450 | NO |
| Example 4 | TaN | 0.5 | 6 | 0.08 | 200 | NO |
| Example 5 | TaN | 4.5 | 15 | 0.3 | 200 | NO |
| Reference 1 | TiN | 2.5 | 3 | 0.83 | 200 | YES |
| Reference 2 | TaN | 2.5 | 3 | 0.83 | 200 | YES |

[Example 6]

First, as illustrated in Fig. 10A, a silicon dioxide layer 2 acting as an underlying insulating layer, and a tungsten wiring layer 3 were deposited in this order on a silicon substrate 1. Then, a silicon dioxide layer 4 was deposited on the tungsten wiring layer 3 by PCVD by a thickness of 600 nm.

Then, a photoresist film (not illustrated) having a thickness of 0.6 μm was formed on the silicon dioxide layer 4, and thereafter, was patterned by means of i-ray having a wavelength of 365 nm. The silicon dioxide layer 4 was etched using the thus patterned photoresist film as a mask, to thereby form a contact hole 5 throughout the silicon dioxide layer 4. The contact hole 5 had a width of 0.18 μm and a length of 15 mm, and reached the tungsten wiring layer 3.

Then, as illustrated in Fig. 10B, a TiN layer 6 as a barrier metal layer was deposited over both the silicon dioxide layer 4 and the exposed tungsten wiring layer 3 by sputtering under the following sputtering conditions.

Sputtering power: 0.5 kW
Sputtering pressure: 3 mTorr
Substrate temperature: 450°C

Then, a copper layer 7 was formed entirely over the TiN layer 6 so that the contact hole 5 was filled with the copper layer 7.

Then, unnecessary portions of the copper layer 7 and the TiN layer 6, that is, portions of the copper layer 7 and the TiN layer 6 existing above the contact hole 5, were removed by CMP under the following conditions.

Polishing slurry: alumina particle
Polishing pressure: 2 psi
r.p.m.: 25
Polishing time: 1 to 2 minutes

Thus, as illustrated in Fig. 10C, there was completed a buried copper contact electrode 8.

The thus formed copper contact electrode 8 had a flat upper surface, which means that dishing was not generated.

As having been described in connection with the embodiments and examples, the present invention prevents generation of dishing, which in turn prevents electro-migration.

In addition, since the present invention prevents generation of dishing by increasing a polishing rate at which a barrier metal layer is polished by CMP, other fabrication conditions are not influenced.

**Claims**

1.   A semiconductor device comprising:

(a) a semiconductor substrate (1);
(b) an insulating layer (4) formed on the semiconductor substrate (1) and formed with at least one recess or hole (5);
(c) a barrier metal layer (6) covering an inner wall of the recess or hole (5) therewith; and
(d) at least one electrically conductive layer (7) formed on the barrier metal layer (6) to fill the recess or hole (5) therewith,
characterized by that assuming that X indicates a maximum depth of a recess or hole (5) in an electrically conductive layer (7) having a longest wiring length, and that Y indicates a thickness of the electrically conductive layer (7) having a longest wiring length, a ratio of Y to X (X/Y) is set equal to or smaller than 0.1.

2. The semiconductor device as set forth in claim 1, wherein the electrically conductive layer (7) is composed of copper or copper compounds, and the barrier metal layer (6) is composed of refractive metal nitride.

3. The semiconductor device as set forth in claim 2, wherein the refractive metal nitride is one of WN, TiN, and TaN.

4. A semiconductor device comprising:

(a) a semiconductor substrate (1);
(b) an insulating layer (4) formed on the semiconductor substrate (1) and formed with at least one recess or hole (5);
(c) a barrier metal layer (6) covering an inner wall of the recess or hole (5) therewith; and
(d) at least one electrically conductive layer (7) formed on the barrier metal layer (6) to fill the recess or hole (5) therewith,
characterized by that a dishing index defined as a resistance to dishing is set equal to or greater than 0.4.

5. The semiconductor device as set forth in claim 4, wherein the electrically conductive layer (7) is composed of copper or copper compounds, and the barrier metal layer (6) is composed of refractive metal nitride.

6. The semiconductor device as set forth in claim 5, wherein the refractive metal nitride is one of WN, TiN, and TaN.

7. A semiconductor device comprising:

(a) a semiconductor substrate (1);
(b) an insulating layer (4) formed on the semiconductor substrate (1) and formed with at least one recess or hole (5);
(c) a barrier metal layer (6) covering an inner wall of the recess or hole (5) therewith, the barrier metal layer (6) having a first polishing rate at which the barrier metal layer (6) is polished by chemical mechanical polishing; and
(d) at least one electrically conductive layer (7) formed on the barrier metal layer (6) to fill the recess or hole (5) therewith, the electrically conductive layer (7) having a second polishing rate at which the electrically conductive layer (7) is polished by chemical mechanical polishing,
characterized by that the first polishing rate is set at least $2.6 \times 10^{-2}$ times greater than the second polishing rate.

8. The semiconductor device as set forth in claim 7, wherein the electrically conductive layer (7) is composed of copper or copper compounds, and the barrier metal layer (6) is composed of refractive metal nitride.

9. The semiconductor device as set forth in claim 8, wherein the refractive metal nitride is one of WN, TiN, and TaN.

10. A semiconductor device comprising:

(a) a semiconductor substrate (1);
(b) an insulating layer (4) formed on the semiconductor substrate (1) and formed with at least one recess or hole (5);
(c) a barrier metal layer (6) covering an inner wall of the recess or hole (5) therewith; and
(d) at least one electrically conductive layer (7) formed on the barrier metal layer (6) to fill the recess or hole (5) therewith,
characterized by that a polishing rate at which the barrier metal layer (6) is polished by chemical mechanical polishing is set equal to or greater than 40 angstroms per minute.

**11.** The semiconductor device as set forth in claim 10, wherein the electrically conductive layer (7) is composed of copper or copper compounds, and the barrier metal layer (6) is composed of refractive metal nitride.

**12.** The semiconductor device as set forth in claim 11, wherein the refractive metal nitride is one of WN, TiN, and TaN.

**13.** A semiconductor device comprising:

(a) a semiconductor substrate (1);
(b) an insulating layer (4) formed on the semiconductor substrate (1) and formed with at least one recess or hole (5);
(c) a barrier metal layer (6) covering an inner wall of the recess or hole (5) therewith; and
(d) at least one electrically conductive layer (7) formed on the barrier metal layer (6) to fill the recess or hole (5) therewith,
characterized by that the barrier metal layer (6) is designed to have a compressive stress equal to or smaller than $3 \times 10^8$ dyne/cm$^2$.

**14.** The semiconductor device as set forth in claim 13, wherein the electrically conductive layer (7) is composed of copper or copper compounds, and the barrier metal layer (6) is composed of refractive metal nitride.

**15.** The semiconductor device as set forth in claim 14, wherein the refractive metal nitride is one of WN, TiN, and TaN.

**16.** A semiconductor device comprising:

(a) a semiconductor substrate (1);
(b) an insulating layer (4) formed on the semiconductor substrate (1) and formed with at least one recess or hole (5);
(c) a barrier metal layer (6) covering an inner wall of the recess or hole (5) therewith; and
(d) at least one electrically conductive layer (7) formed on the barrier metal layer (6) to fill the recess or hole (5) therewith,
characterized by that the barrier metal layer (6) is designed to have a density equal to or smaller than $6 \times 10^{22}$ atoms/cm$^3$.

**17.** The semiconductor device as set forth in claim 16, wherein the electrically conductive layer (7) is composed of copper or copper compounds, and the barrier metal layer (6) is composed of refractive metal nitride.

**18.** The semiconductor device as set forth in claim 17, wherein the refractive metal nitride is one of WN, TiN, and TaN.

**19.** A method of fabricating a semiconductor device, comprising the steps of:

(a) forming an insulating layer (4) on a semiconductor substrate (1);
(b) forming a recess or hole (5) with the insulating film;
(c) forming a barrier metal layer (6) over an inner wall of the recess or hole (5) by sputtering;
(d) forming an electrically conductive layer (7) over the barrier metal layer (6) to fill the recess or hole (5) therewith, and over the insulating layer (4); and
(e) removing the electrically conductive layer (7) by chemical mechanical polishing in such a manner that the recess or hole (5) remains filled with the electrically conductive layer (7),
characterized by at least one of the following features:

(A) the sputtering is carried out at sputtering power equal to or smaller than 1.5 kW;
(B) the sputtering being carried out at sputtering pressure equal to or greater than 8 mTorr; and
(C) the sputtering being carried out under a temperature of the substrate (1) being equal to or greater than 360 degrees centigrade.

**20.** A method of fabricating a semiconductor device, comprising the steps of:

(a) forming an insulating film (4) on a semiconductor substrate (1);
(b) forming a recess or hole (5) with the insulating film (4);
(c) forming a barrier metal layer (6) over an inner wall of the recess or hole (5) by sputtering;

(d) forming an electrically conductive layer (7) over the barrier metal layer (6) to fill the recess or hole (5) therewith, and over the insulating film (4); and

(e) removing the electrically conductive layer (7) by chemical mechanical polishing in such a manner that the recess or hole (5) remains filled with the electrically conductive layer (7),

characterized by that the sputtering is carried out under following conditions:

$$W/P \leqq 0.4 \text{ and } T \geqq 200$$

wherein W indicates a sputtering power in the unit of kW, P indicates a sputtering pressure in the unit of mTorr, and T indicates a substrate temperature when the sputtering is carried out, in the unit of degrees centigrade.

21. The method as set forth in claim 20, wherein the electrically conductive layer (7) is composed of copper or copper compounds, and the barrier metal layer (6) is composed of TiN.

22. The method as set forth in claim 20 or 21, wherein the electrically conductive layer (7) is composed of copper or copper compounds, and the barrier metal layer (6) is composed of TaN, and wherein the sputtering is carried out under following conditions:

$$W/P \leqq 0.35 \text{ and } T \geqq 200$$

wherein W indicates a sputtering power in the unit of kW, P indicates a sputtering pressure in the unit of mTorr, and T indicates a substrate temperature when the sputtering is carried out, in the unit of degrees centigrade.

## FIG.1A
### PRIOR ART

5

4

3

2

1

## FIG.1B
### PRIOR ART

7

6

4

3

2

1

## FIG.1C
### PRIOR ART

8

6

4

3

2

1

## FIG.2

## FIG.3

FIG.4

POLISHING RATE [ Å / min ]

COMPRESSIVE STRESS [ X 10$^8$dyne / cm$^2$ ]

FIG.5

FIG.6

FIG.7

FIG.8

FIG.9

**FIG.10A**

**FIG.10B**

**FIG.10C**